# EUROPEAN PATENT APPLICATION

(11) **EP 4 761 506 A1**
(43) Date of publication of application: **17.06.2026**
(21) Application number: 24905651.6
(22) Date of filing: 03.09.2024
(51) Int. Cl.: H10D 30/60, H10D 62/10, H10D 30/01

(54) **TRENCH-GATE-TYPE SILICON CARBIDE POWER DEVICE, MANUFACTURING METHOD THEREFOR AND SEMICONDUCTOR STRUCTURE**

(30) Priority: 21.12.2023 CN 202311769736
(71) Applicant: Zhuhai Gree Electronic Components Co., Ltd., Zhuhai, Guangdong 519070 (CN); Gree Electric Appliances, Inc. of Zhuhai, Zhuhai, Guangdong 519070 (CN)
(72) Inventor: ZHANG, Peng, Zhuhai, Guangdong 519070 (CN); FENG, Yin, Zhuhai, Guangdong 519070 (CN)
(74) Representative: Zacco GmbH
(86) International application number: PCT/CN2024/116643
(87) International publication number: WO 2025/130159

(57) **Abstract**

The present disclosure provides a trench-gate-type silicon carbide power device, a method for manufacturing thereof, and a semiconductor structure. The device includes: a substrate; an epitaxial layer, which is located on a surface of the substrate; a trench gate, which is at least located in the epitaxial layer; at least one first injection region, which is located in the epitaxial layer on at least one side of the trench gate and is in contact with part of a side wall of the trench gate, a surface of the first injection region away from the substrate being overlapped with part of a surface of the epitaxial layer away from the substrate; at least one second injection region, which is located in the epitaxial layer on at least one side of the trench gate, is in contact with part of the side wall of the trench gate, and is further in contact with a surface of the at least one first injection region close to the substrate; and a third injection region, which is located in the epitaxial layer and is in contact with part of a bottom of the trench gate, part of the side wall of the trench gate and part of a surface of the at least one second injection region close to the substrate respectively, where conduction types of the epitaxial layer, the first injection region and the third injection region are the same and are different from a conduction type of doped ions of the second injection region, and a doping concentration of the third injection region is greater than a doping concentration of the epitaxial layer.

## Description

### Cross-Reference to Related Application

The present disclosure claims priority to Chinese Patent Application No. 2023117697360 filed to the China National Intellectual Property Administration on December 21, 2023 and entitled "Trench-Gate-Type Silicon Carbide Power Device, Method for manufacturing Thereof, and Semiconductor Structure", the disclosure of which is incorporated by reference in its entirety.

### Technical Field

The present disclosure relates to the field of the semiconductor technology, specifically to a trench-gate-type silicon carbide power device, a method for manufacturing thereof, and a semiconductor structure.

### Background

The development of the performance of power semiconductor devices profoundly constrains the efficiency and application of the entire power electronic system. Compared to silicon-based materials, the SiC MOSFET (Metal-Oxide-Semiconductor Field-Effect Transistor) has the advantages of high breakdown electric field strength, low conduction resistance, fast working frequency and the like, may meet the performance requirements of high voltage, low conduction loss and miniaturization, and is widely used in fields such as aerospace, electric vehicles and rail traffic.

A trench gate structure may reduce a cell size and make a chip size smaller, which has become a current research hotspot. How to reduce the conduction resistance of a trench-gate-type SiC power device is an urgent technical problem that needs to be solved.

### Summary

The main purpose of the present disclosure is to provide a trench-gate-type silicon carbide power device, a method for manufacturing thereof, and a semiconductor structure, so as to at least solve the problem of relatively high conduction resistance of a trench-gate-type silicon carbide power device in the prior art.

In order to achieve the above purpose, according to one aspect of the present disclosure, a trench-gate-type silicon carbide power device is provided. The trench-gate-type silicon carbide power device includes: a substrate; an epitaxial layer, which is located on a surface of the substrate; a trench gate, which is at least located in the epitaxial layer; at least one first injection region, which is located in the epitaxial layer on at least one side of the trench gate and is in contact with part of a side wall of the trench gate, a surface of the at least one first injection region away from the substrate being overlapped with part of a surface of the epitaxial layer away from the substrate; at least one second injection region, which is located in the epitaxial layer on at least one side of the trench gate, is in contact with part of the side wall of the trench gate, and is further in contact with a surface of the at least one first injection region close to the substrate; and a third injection region, which is located in the epitaxial layer and is in contact with part of a bottom of the trench gate, part of the side wall of the trench gate and part of a surface of the at least one second injection region close to the substrate respectively, and conduction types of doped ions of the epitaxial layer, doped ions of the at least one first injection region and doped ions of the third injection region being the same and being different from a conduction type of doped ions of the at least one second injection region, and a doping concentration of the doped ions of the third injection region being greater than a doping concentration of the doped ions of the epitaxial layer.

Optionally, the trench-gate-type silicon carbide power device further includes: a fourth injection region, which is located in the epitaxial layer, is in contact with part of a surface of the third injection region close to the substrate and is further in contact with part of the bottom of the trench gate, conduction types of doped ions of the fourth injection region and the doped ions of the epitaxial layer being different.

Optionally, the fourth injection region wraps a bottom corner of the trench gate.

Optionally, both first injection regions and second injection regions are located on two sides of the trench gate and are in contact with parts of two side walls of the trench gate respectively, and the third injection region only covers one bottom corner of the trench gate and part of the side wall of the trench gate located on a same side of the bottom corner and the surface of one of the second injection regions close to the substrate located on the same side of the bottom corner.

Optionally, the trench-gate-type silicon carbide power device further includes: an interlayer insulation layer, which is located on a surface of the trench gate away from the substrate and the surface of the at least one first injection region away from the substrate; a source electrode metal layer, which is located on a surface of the epitaxial layer away from the substrate and a surface of the interlayer insulation layer away from the substrate; and a drain electrode metal layer, which is located on a surface of the substrate away from the epitaxial layer.

Optionally, the trench gate includes: a trench, which is located in the epitaxial layer; a gate oxide layer, which is located on side walls of the trench, a bottom of the trench and part of the surface of the at least one first injection region away from the substrate; and a gate electrode, which is located on a surface of the gate oxide layer away from the substrate, a surface of the gate electrode away from the substrate being flush with the surface of the gate oxide layer away from the at least one first injection region.

Optionally, the trench-gate-type silicon carbide power device further includes: at least one fifth injection region, which is located in the epitaxial layer on at least one side of the trench gate, is in contact with the surface of the at least one first injection region away from the side wall of the trench gate, and is further in contact with part of the surface of the at least one second injection region away from the substrate, and a surface of the at least one fifth injection region away from the substrate being overlapped with part of the surface of the epitaxial layer away from the substrate, conduction types of doped ions of the at least one fifth injection region and the doped ions of the at least one second injection region being the same, and a doping concentration of doped ions of the at least one fifth injection region being greater than the doping concentration of doped ions of the at least one second injection region.

According to another aspect of the present disclosure, a method for manufacturing the trench-gate-type silicon carbide power device is provided. The method includes: a substrate and an initial epitaxial layer located on the substrate are provided; a first initial injection region, a second initial injection region and a third initial injection region are formed in the initial epitaxial layer, a surface of the first initial injection region away from the substrate being overlapped with part of a surface of the initial epitaxial layer away from the substrate, the second initial injection region being located on a surface of the first initial injection region close to the substrate, the third initial injection region being located on part of a surface of the second initial injection region close to the substrate, conduction types of doped ions of the initial epitaxial layer, doped ions of the first initial injection region and doped ions of the third initial injection region being the same and being different from a conduction type of doped ions of the second initial injection region, and a doping concentration of the doped ions of the third initial injection region being greater than a doping concentration of the doped ions of the initial epitaxial layer; and a trench gate located in the initial epitaxial layer is formed, the trench gate sequentially penetrating through the first initial injection region and the second initial injection region, part of a bottom of the trench gate being located in the third initial injection region, a remaining first initial injection region forming at least one first injection region, a remaining second initial injection region forming at least one second injection region, a remaining third initial injection region forming a third injection region, and a remaining initial epitaxial layer forming an epitaxial layer.

Optionally, the first initial injection region, the second initial injection region and the third initial injection region are formed in the initial epitaxial layer including: a fourth initial injection region is formed in the initial epitaxial layer, a width of the fourth initial injection region in a first direction being the same as a width of the initial epitaxial layer in the first direction, a width of the fourth initial injection region in a second direction being less than a width of the initial epitaxial layer in the second direction, conduction types of doped ions of the fourth initial injection region and the doped ions of the initial epitaxial layer being different, the first direction being perpendicular to a stacking direction of the substrate and the initial epitaxial layer, and the second direction being parallel to the stacking direction; the first initial injection region is formed in the fourth initial injection region, a width of the first initial injection region in the first direction being less than the width of the fourth initial injection region in the first direction, a width of the first initial injection region in the second direction being less than the width of the fourth initial injection region in the second direction, and a remaining fourth initial injection region forming the second initial injection region; a fifth initial injection region is formed in the initial epitaxial layer, the fifth initial injection region being located on part of the surface of the second initial injection region close to the substrate, and conduction types of doped ions of the fifth initial injection region and the doped ions of the initial epitaxial layer being different; the third initial injection region located in the initial epitaxial layer and the fifth initial injection region is formed, the third initial injection region being in contact with the surface of the second initial injection region close to the substrate, and a remaining fifth initial injection region forming a middle injection region; the trench gate located in the initial epitaxial layer is formed including: part of the first initial injection region, part of the second initial injection region, part of the third initial injection region and part of the middle injection region are removed, to form a trench with part of the bottom located in the third initial injection region and a remaining bottom in contact with the middle injection region, the remaining first initial injection region forming the at least one first injection region, the remaining second initial injection region forming the second injection region, the remaining third initial injection region forming the third injection region, a remaining middle injection region forming the fourth injection region, and the remaining initial epitaxial layer forming the epitaxial layer; the trench and part of the surface of the at least one first injection region away from the substrate are covered with a gate oxide layer; and a remaining trench is filled with a conductive material to form a gate electrode, a surface of the gate electrode away from the substrate being flush with a surface of the gate oxide layer away from the at least one first injection region, and the gate electrode and the gate oxide layer forming the trench gate.

According to still another aspect of the present disclosure, a semiconductor structure is provided. The semiconductor structure includes: any one of the trench-gate-type silicon carbide power devices, or the trench-gate-type silicon carbide power device manufactured by the method.

By applying the technical solutions of the present disclosure, the third injection region with the same doping type of doped ions as the epitaxial layer is provided in the epitaxial layer at the bottom of the trench gate, and the doping concentration of doped ions of the third injection region is higher than the doping concentration of doped ions of the epitaxial layer. Due to the presence of the third injection region, when a voltage is applied to the gate electrode and source electrode of the trench-gate-type silicon carbide power device and reaches a device threshold voltage, a carrier path from the first injection region through the second injection region and the third injection region to the epitaxial layer is formed first, that is, carriers pass through the first injection region, flow through an inversion layer channel formed in the second injection region, and then flow towards the epitaxial layer and the substrate through the third injection region, thereby ensuring relatively small path resistance, and effectively solving the technical problem of relatively high conduction resistance of a trench-gate-type silicon carbide power device in the prior art.

### Brief Description of the Drawings

The accompanying drawings of the specification, constituting a part of the present disclosure, are used to provide a further understanding for the present disclosure. Exemplary embodiments of the present disclosure and descriptions thereof are used to explain the present disclosure, but do not constitute any improper limitation on the present disclosure. In the accompanying drawings:
Fig. 1 shows a schematic structural diagram of a trench-gate-type silicon carbide power device according to an embodiment of the present disclosure;
Fig. 2 shows a schematic flowchart of a method for manufacturing a trench-gate-type silicon carbide power device according to an embodiment of the present disclosure; and
Fig. 3 to Fig. 12 show schematic structural diagrams obtained after each process step of a method for manufacturing a trench-gate-type silicon carbide power device according to an embodiment of the present disclosure.

The accompanying drawings have the following reference numerals:
10. substrate; 11. epitaxial layer; 12. trench gate; 13. first injection region; 14. second injection region; 15. third injection region; 16. fourth injection region; 17. interlayer insulation layer; 18. source electrode metal layer; 19. drain electrode metal layer; 20. gate oxide layer; 21. gate electrode; 22. initial epitaxial layer; 23. first initial injection region; 24. second initial injection region; 25. third initial injection region; 26. fourth initial injection region; 27. fifth initial injection region; 28. trench; 29. sixth initial injection region; 30. fifth injection region; 31. middle injection region.

### Detailed Description of the Embodiments

It should be noted that in the case of no conflict, embodiments in the present disclosure and features in the embodiments may be combined with each other. The present disclosure will be described in detail below with reference to the accompanying drawings in conjunction with the embodiments.

In order to enable those skilled in the art to better understand the solutions in the present disclosure, the technical solutions in the embodiments of the present disclosure will be described clearly and completely below with reference to the accompanying drawings in the embodiments of the present disclosure. It is apparent that the described embodiments are only a part of the embodiments of the present disclosure, rather than all of the embodiments. All other embodiments obtained by those of ordinary skill in the art based on the embodiments in the present disclosure without creative efforts shall fall within the scope of protection of the present disclosure.

It should be noted that the terms "first", "second", and the like in the specification and claims of the present disclosure and the accompanying drawings are used to distinguish similar objects, but are not intended to describe a particular sequence or a precedence order. It should be understood that the data used in this way may be interchanged in appropriate circumstances to facilitate the embodiments of the present disclosure described herein. In addition, the terms "include" and "have" and any variants thereof are intended to cover non-exclusive inclusions. For example, a process, method, system, product, or device that includes a series of steps or units is not necessarily limited to those steps or units that are clearly listed, but may include other steps or units not clearly listed or inherent to such process, method, product, or device.

As introduced in the background art, the conduction resistance of a trench-gate-type silicon carbide power device in the prior art is relatively high. In order to solve the above technical problem, embodiments of the present disclosure provide a trench-gate-type silicon carbide power device, a method for manufacturing thereof, and a semiconductor structure.

The technical solutions in the embodiments of the present disclosure will be clearly and completely described below with reference to the accompanying drawings in the embodiments of the present disclosure.

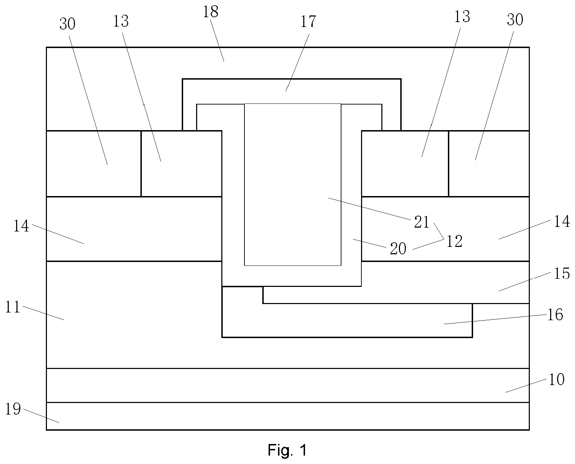

This embodiment provides a trench-gate-type silicon carbide power device as shown in Fig. 1, specifically including:
a substrate 10;
an epitaxial layer 11, which is located on a surface of the substrate 10; and
specifically, the materials of the substrate and the epitaxial layer are respectively silicon carbide; the conduction types of doped ions of the substrate and the epitaxial layer are the same, for example, the substrate is an n-type conductive substrate, and the epitaxial layer is an n-type epitaxial layer; the doping concentration of doped ions of the substrate is greater than the doping concentration of doped ions of the epitaxial layer; those skilled in the art may flexibly set doping concentration values of doped ions of the substrate and doped ions of the epitaxial layer according to actual design requirements; in an optional embodiment, the doping concentration of doped ions of the substrate is E19 cm⁻³-E20 cm⁻³, and the doping concentration of doped ions of the epitaxial layer is E15 cm⁻³-E16 cm⁻³;
a trench gate 12, which is at least located in the epitaxial layer 11;
at least one first injection region 13, which is located in the epitaxial layer 11 on at least one side of the trench gate 12 and is in contact with part of a side wall of the trench gate 12, a surface of the at least one first injection region 13 away from the substrate 10 being overlapped with part of a surface of the epitaxial layer 11 away from the substrate 10;
specifically, the first injection region may be only in contact with part of one side wall of the trench gate, or may be in contact with parts of two side walls of the trench gate respectively as shown in Fig. 1; the first injection region extends from the surface of the epitaxial layer into the epitaxial layer, the depth of the first injection region is less than the depth of the epitaxial layer and is also less than the depth of the trench gate in the epitaxial layer, and the depth is a depth value in the direction parallel to the stacking direction of the substrate and the epitaxial layer;
at least one second injection region 14, which is located in the epitaxial layer 11 on at least one side of the trench gate 12, is in contact with part of the side wall of the trench gate 12, and is further in contact with a surface of the at least one first injection region 13 close to the substrate 10;
specifically, the second injection region may be only in contact with part of one side wall of the trench gate, or may be in contact with parts of two side walls of the trench gate respectively as shown in Fig. 1; in a case that the first injection region is only in contact with part of one side wall of the trench gate, the second injection region and the first injection region are located on the same side of the trench gate; the total depth of the second injection region and the first injection region is less than or equal to the depth of the trench gate in the epitaxial layer; and
a third injection region 15, which is located in the epitaxial layer 11 and is in contact with part of a bottom of the trench gate 12, part of the side wall of the trench gate 12 and part of a surface of the at least one second injection region 14 close to the substrate 10 respectively, that is to say, the third injection region 15 at least wraps a bottom corner of the trench gate 12;
where conduction types of doped ions of the epitaxial layer, doped ions of the at least one first injection region and doped ions of the third injection region are the same and are different from a conduction type of doped ions of the at least one second injection region, and a doping concentration of the doped ions of the third injection region is greater than a doping concentration of the doped ions of the epitaxial layer.

Specifically, the conduction type of doped ions of the second injection region is different from the conduction types of doped ions of the epitaxial layer, the first injection region and the third injection region, for example, in a case that the conduction type of doped ions of the second injection region is a p type, the conduction types of doped ions of the epitaxial layer, the first injection region and the third injection region are all an n type. Those skilled in the art may flexibly set the doping concentration of doped ions of the third injection region according to actual design requirements. In this embodiment, the doping concentration of doped ions of the third injection region is E17-E19 cm⁻³.

Through the embodiment, the third injection region with the same doping type of doped ions as the epitaxial layer is provided in the epitaxial layer at the bottom of the trench gate, and the doping concentration of doped ions of the third injection region is higher than the doping concentration of doped ions of the epitaxial layer. Due to the presence of the third injection region, when a voltage is applied to the gate electrode and source electrode of the trench-gate-type silicon carbide power device and reaches a device threshold voltage, a carrier path from the first injection region through the second injection region and the third injection region to the epitaxial layer is formed first, that is, carriers pass through the first injection region, flow through an inversion layer channel formed in the second injection region, and then flow towards the epitaxial layer and the substrate through the third injection region, thereby ensuring relatively small path resistance, and effectively solving the technical problem of relatively high conduction resistance of a trench-gate-type silicon carbide power device in the prior art.

In another specific embodiment, the doping concentration of doped ions of the first injection region is greater than the doping concentration of doped ions of the third injection region. The doping concentration of doped ions of the first injection region specifically may be E19-E20 cm⁻³.

In the prior art, since the dielectric constant of SiO₂ is 1/3 that of SiC, the electric field in the gate oxide of the trench gate is about 3 times that of SiC, which may cause the electric field at the bottom of the gate electrode of the trench-gate-type silicon carbide power device in a reverse state to be too large, resulting in the problem of gate oxygen breakdown, thereby reducing the breakdown voltage. In view of the problem, in an optional embodiment of the present disclosure, as shown in Fig. 1, the trench-gate-type silicon carbide power device further includes: a fourth injection region 16, which is located in the epitaxial layer 11, is in contact with part of a surface of the third injection region 15 close to the substrate 10 and is further in contact with part of the bottom of the trench gate 12, the conduction types of doped ions of the fourth injection region 16 and doped ions of the epitaxial layer 11 being different.

In the embodiment, the fourth injection region with a conduction type of doped ions different from that of the epitaxial layer is provided at the bottom of the trench gate, so that the fourth injection region is in contact with part of the bottom of the trench gate and the third injection region respectively, and the fourth injection region and the second injection region respectively form PN junctions with the epitaxial layer. In this way, when a reverse voltage is applied to the trench-gate-type silicon carbide power device to enable the device to operate in a reverse state, by setting the conduction types of doped ions of the second injection region, the fourth injection region and the epitaxial layer, the PN junction formed by the fourth injection region and the epitaxial layer as well as the PN junction formed by the second injection region and the epitaxial layer are in a reverse biased state. In addition, as the reverse voltage increases, depletion layers of the two PN junctions are gradually expanded and connected, thereby effectively solving the problem of electric field concentration at the bottom of the trench, and ensuring that the breakdown voltage of the trench-gate-type silicon carbide power device is relatively high and the overall reliability of the device is better.

Further, the fourth injection region may be only in contact with the bottom of the trench gate. In order to further ensure better reliability of the device, in the present disclosure, the fourth injection region wraps the bottom corner of the trench gate. Since high electric fields are mainly concentrated at the bottom corner of the trench gate, by enabling the fourth injection region to wrap the bottom corner to form a corner wrapping trench shielding structure of the trench gate, the gate oxide layer of the bottom corner of the trench gate may be effectively protected, so as to further solve the problem of high electric field concentration at the bottom corner of the trench gate, and further improve the reliability of the trench gate.

In an actual application process, the doping concentrations of doped ions of the second injection region and the fourth injection region may be any suitable concentration value. In a specific embodiment, the doping concentrations of doped ions of the second injection region and the fourth injection region are respectively E17-E18 cm⁻³.

According to another exemplary solution of the present disclosure, as shown in Fig. 1, both the first injection regions 13 and the second injection regions 14 are located on two sides of the trench gate 12 and are in contact with parts of two side walls of the trench gate 12 respectively. The third injection region 15 only covers one bottom corner of the trench gate 12 and part of the side wall of the trench gate 12 located on a same side of the bottom corner and the surface of one of the second injection regions 14 close to the substrate 10 located on the same side of the bottom corner, and does not cover the other bottom corner of the trench gate 12 and the surface of the second injection region 14 close to the substrate 10 located on the other side of the trench gate 12. In the embodiment, a plurality of conducting channels are formed through the first injection regions and second injection regions located on two sides of the trench gate as well as the third injection region and the fourth injection region in contact with one second injection region, where the plurality of conducting channels include: a conducting channel formed by one first injection region, one second injection region, the third injection region and the epitaxial layer located on one side of the trench gate, a conducting channel formed by one first injection region, one second injection region and the epitaxial layer located on the other side of the trench gate, and a conducting channel formed by one first injection region, one second injection region, the third injection region, the fourth injection region and the epitaxial layer located on one side of the trench gate, thereby further reducing the conduction resistance of the device, and increasing the current density of the device.

In a specific application process, as shown in Fig. 1, the trench-gate-type silicon carbide power device further includes: an interlayer insulation layer 17, which is located on a surface of the trench gate 12 away from the substrate and the surface of the at least one first injection region 13 away from the substrate 10; a source electrode metal layer 18, which is located on a surface of the epitaxial layer 11 away from the substrate and a surface of the interlayer insulation layer 17 away from the substrate 10; and a drain electrode metal layer 19, which is located on a surface of the substrate 10 away from the epitaxial layer 11. In this embodiment, isolation and protection of the trench gate are achieved through the interlayer insulation layer. The source electrode metal layer serves as a source electrode of the device, and the drain electrode metal layer serves as a drain electrode of the device.

In the embodiment of the present disclosure, suitable materials may be selected as the materials of the interlayer insulation layer, such as silicon dioxide, silicon nitride and aluminum oxide, etc. Of course, in addition to the mentioned materials, other insulating materials may also be selected as the materials of the interlayer insulation layer. Similarly, those skilled in the art may select any suitable conductive material as the material of the source electrode metal layer and the drain electrode metal layer, and the source electrode metal layer and the drain electrode metal layer may select a single-layer conductive structure or a multi-layer conductive structure. In an optional solution, the source electrode metal layer has a multi-layer conductive structure and specifically includes a first metal layer, a second metal layer and a third metal layer stacked in sequence along a direction away from the epitaxial layer, where the first metal layer is an Ni layer, the second metal layer is a Ti layer, and the third metal layer is an Al layer. The drain electrode metal layer also has a multi-layer conductive structure and specifically includes a fourth metal layer, a fifth metal layer, a sixth metal layer and a seventh metal layer stacked in sequence along a direction away from the substrate, where the fourth metal layer is an Ni layer, the fifth metal layer is a Ti layer, the sixth metal layer is an Ni layer, and the seventh metal layer is an Ag layer. In this embodiment, a stacked metal material is used as the drain electrode metal layer and the source electrode metal layer, so that the drain electrode metal layer and the substrate may form good ohmic contact, and the source electrode metal layer and the first injection region may form good ohmic contact, thereby further ensuring better overall performance of the semiconductor device. Of course, in addition to the mentioned metal materials, other single conductive materials or alloy materials may also be selected for the source electrode metal layer and the drain electrode metal layer in the present disclosure.

In order to further ensure better performance of the trench-gate-type silicon carbide power device, specifically, as shown in Fig. 1, the trench-gate-type silicon carbide power device further includes: at least one fifth injection region 30, which is located in the epitaxial layer 11 on at least one side of the trench gate 12, that is, the fifth injection region 30 may be only located in the epitaxial layer on one side of the trench gate or may also be located in the epitaxial layer on two sides of the trench gate. The at least one fifth injection region 30 is in contact with the surface of the at least one first injection region 13 away from the side wall of the trench gate 12, the at least one fifth injection region 30 is further in contact with part of the surface of the at least one second injection region 14 away from the substrate 10, a surface of the at least one fifth injection region 30 away from the substrate 10 is overlapped with part of the surface of the epitaxial layer 11 away from the substrate 10, the conduction types of doped ions of the fifth injection region 30 and doped ions of the second injection region 14 are the same, and the doping concentration of doped ions of the fifth injection region 30 is greater than the doping concentration of doped ions of the second injection region 14. Through the fifth injection region, parasitic triode conduction of the device may be prevented.

In a specific embodiment, the doping concentration of doped ions of the fifth injection region may be E19-E21 cm⁻³.

Those skilled in the art may select any suitable doped ions to form the substrate, the epitaxial layer and each injection region in the present disclosure in an ion injection manner or other doping manners. In a case that the doping type is an n type, nitrogen ions and phosphorus ions may be selected as doped ions. In a case that the doping type is a p type, aluminum ions and boron ions may be selected as doped ions.

Optionally, as shown in Fig. 1, the trench gate 12 includes: a trench (not shown in Fig. 1), which is located in the epitaxial layer 11; a gate oxide layer 20, which is located on side walls of the trench, a bottom of the trench and part of the surface of the at least one first injection region 13 away from the substrate 10; and a gate electrode 21, which is located on a surface of the gate oxide layer 20 away from the substrate 10, a surface of the gate electrode 21 away from the substrate 10 being flush with the surface of the gate oxide layer 20 away from the at least one first injection region 13.

The materials of the gate electrode and the gate oxide layer may be selected from any feasible materials in the prior art. In an exemplary embodiment, the material of the gate electrode includes polycrystalline silicon, and the material of the gate oxide layer includes silicon oxide.

In the exemplary embodiment of the present disclosure, a thickness range of the gate oxide layer is 40-60 nm.

Specifically, taking a device structure in which the doping type of doped ions of the epitaxial layer is an n type, and the first injection regions, the second injection regions and the fifth injection regions are all located in the epitaxial layer on two sides of the trench gate as an example, the working principle of the trench-gate-type silicon carbide power device of the present disclosure is described as follows:
When a positive voltage (Vgs is greater than 0) is applied to the gate electrode-source electrode of the trench-gate-type silicon carbide power device, the surfaces of the second injection region and the fourth injection region with a p doping type close to the gate oxide layer enter a weak inversion state. As the gate-source voltage increases and exceeds the device threshold voltage, the surfaces of the second injection region and the fourth injection region close to the gate oxide layer enter a strong inversion state to form a conductive channel, and the device starts working. First, electrons pass through the first injection region on the right side of the trench gate, flow through the N-type inversion layer channel formed in the second injection region on the right side of the trench gate, then flow through the third injection region, and subsequently flow towards the epitaxial layer and the substrate; then, as the gate-source voltage continues to increase, the electrons simultaneously flow from the first injection region on the left side of the trench gate, through the N-type inversion layer channel formed in the second injection region on the left side of the trench gate, and then into the epitaxial layer and the substrate; and then, as the gate-source voltage continues to increase, the electrons simultaneously flow through the first injection region on the right side of the trench gate, the N-type inversion layer channel formed in the second injection region on the right side of the trench gate, the third injection region and the N-type inversion layer channel formed in the fourth injection region, and into the epitaxial layer and the substrate. The channel formed by the first injection region, the second injection region, the third injection region, the epitaxial layer and the substrate on the right side of the trench gate is formed first. Due to the presence of the third injection region, the path resistance of the device is relatively small.

When the device operates in a reverse state, the PN junction formed by the fourth injection region and the epitaxial layer is in a reverse biased state, and the PN junction formed by the second injection region and the epitaxial layer is in a reverse biased state. As the reverse voltage increases, the formed PN junction depletion layers begin to expand and connect, so as to avoid the phenomenon of high electric field concentration at the bottom of the trench.

Each structural layer may be formed by any suitable manufacturing method, such as one or more of CVD (Chemical Vapor Deposition), ALD (Atomic Layer Deposition), PVD (Physical Vapor Deposition), thermal oxidation, molecular beam epitaxy, metal organic chemical vapor deposition, metal organic vapor phase epitaxy, hydride vapor phase epitaxy, and/or other well-known crystal growth processes.

This embodiment provides a method for manufacturing the trench-gate-type silicon carbide power device. It should be noted that although a logical sequence is shown in the flowchart, in some cases, the steps shown or described may be performed in a sequence different from that shown here.

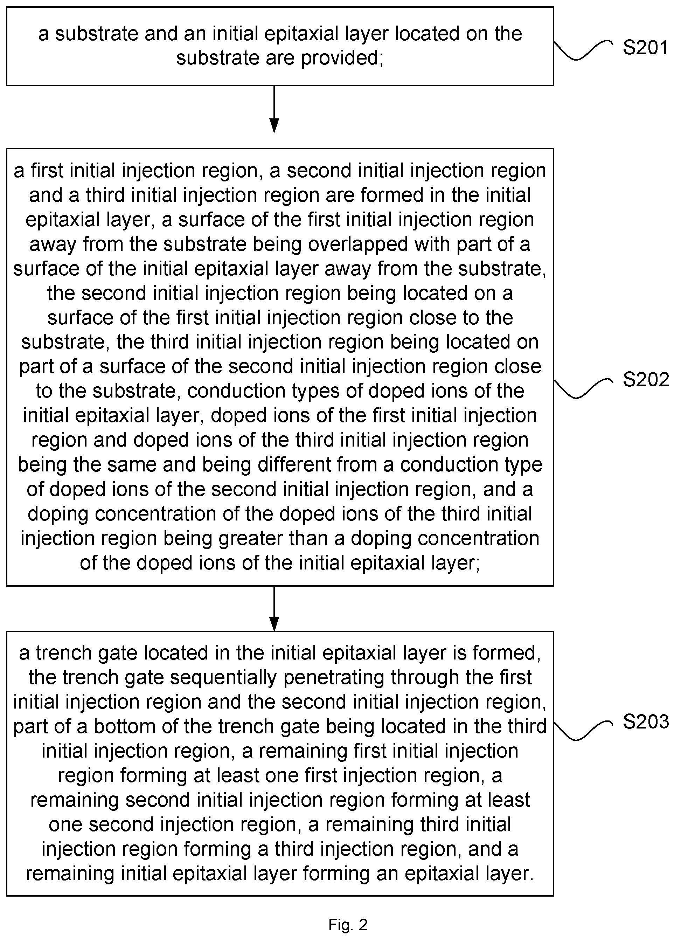

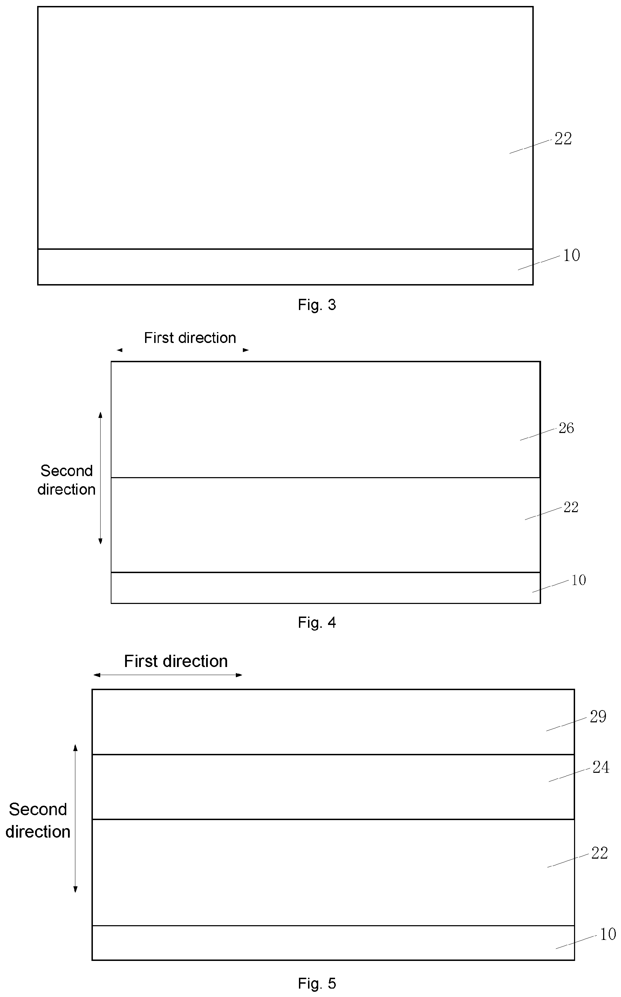

Fig. 2 is a flowchart of a method for manufacturing a trench-gate-type silicon carbide power device according to an embodiment of the present disclosure. As shown in Fig. 2, the method includes the following steps:
Step S201: a substrate 10 as shown in Fig. 3 and an initial epitaxial layer 22 located on the substrate 10 are provided.

Specifically, the materials of the substrate and the initial epitaxial layer are respectively silicon carbide. The conduction types of doped ions of the substrate and the initial epitaxial layer are the same, for example, the substrate is an n-type conductive substrate, and the initial epitaxial layer is an n-type initial epitaxial layer. The doping concentration of doped ions of the substrate is greater than the doping concentration of doped ions of the initial epitaxial layer. Those skilled in the art may flexibly set doping concentration values of doped ions of the substrate and doped ions of the initial epitaxial layer according to actual design requirements. In an optional embodiment, the doping concentration of doped ions of the substrate is E19 cm⁻³-E20 cm⁻³, and the doping concentration of doped ions of the initial epitaxial layer is E15 cm⁻³-E16 cm⁻³.

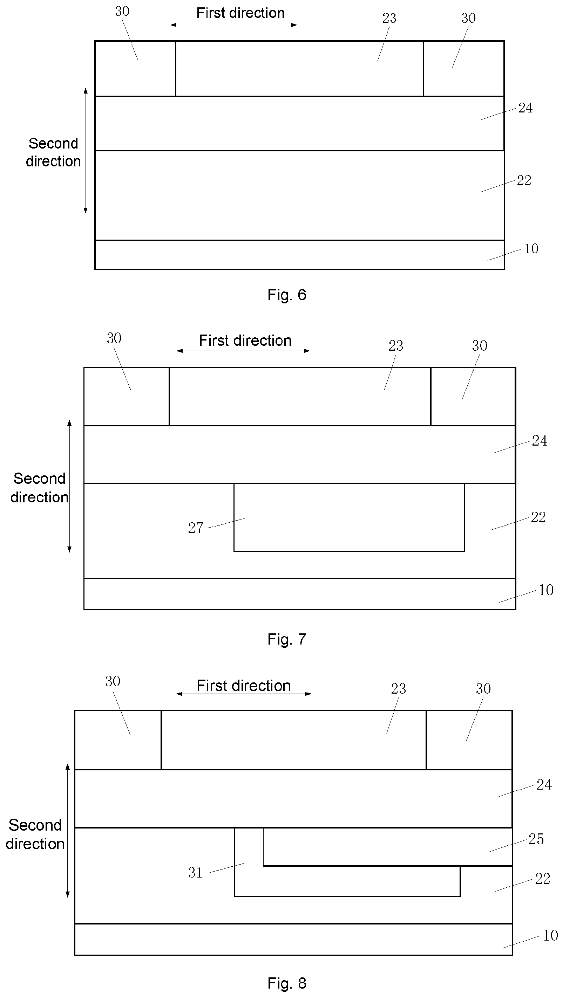

Step S202: a first initial injection region 23, a second initial injection region 24 and a third initial injection region 25 are formed in the initial epitaxial layer 22 to obtain a structure as shown in Fig. 8, a surface of the first initial injection region 23 away from the substrate 10 being overlapped with part of a surface of the initial epitaxial layer 22 away from the substrate 10, the second initial injection region 24 being located on a surface of the first initial injection region 23 close to the substrate 10, the third initial injection region 25 being located on part of a surface of the second initial injection region 24 close to the substrate 10, conduction types of doped ions of the initial epitaxial layer 22, doped ions of the first initial injection region 23 and doped ions of the third initial injection region 25 being the same and being different from a conduction type of doped ions of the second initial injection region 24, and a doping concentration of the doped ions of the third initial injection region 25 being greater than a doping concentration of the doped ions of the initial epitaxial layer 22.

Specifically, the conduction type of doped ions of the second initial injection region is different from the conduction types of doped ions of the initial epitaxial layer, the first initial injection region and the third initial injection region, for example, in a case that the conduction type of doped ions of the second initial injection region is a p type, the conduction types of doped ions of the initial epitaxial layer, the first initial injection region and the third initial injection region are all an n type. Those skilled in the art may flexibly set the doping concentration of doped ions of the third initial injection region according to actual design requirements. In this embodiment, the doping concentration of doped ions of the third initial injection region is E17-E19 cm⁻³.

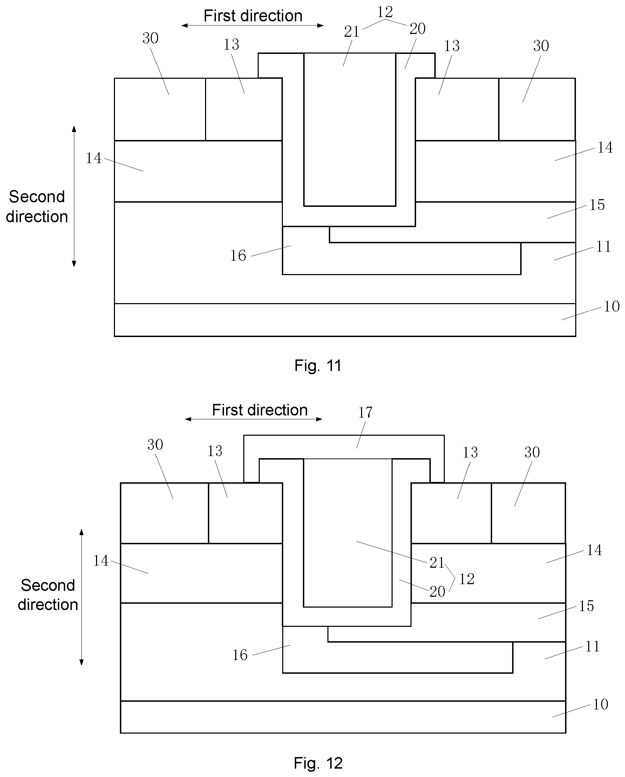

Step S203: as shown in Fig. 11, a trench gate 12 located in the initial epitaxial layer 22 is formed, the trench gate 12 sequentially penetrating through the first initial injection region 23 and the second initial injection region 24, part of a bottom of the trench gate 12 being located in the third initial injection region 25, a remaining first initial injection region 23 forming at least one first injection region 13, a remaining second initial injection region 24 forming at least one second injection region 14, a remaining third initial injection region 25 forming a third injection region 15, and a remaining initial epitaxial layer 22 forming an epitaxial layer 11, thereby obtaining a structure as shown in Fig. 1.

Specifically, the at least one first initial injection region may be only in contact with part of one side wall of the trench gate, or may be in contact with parts of two side walls of the trench gate respectively. The at least one first initial injection region extends from the surface of the initial epitaxial layer into the initial epitaxial layer, the depth of the at least one first initial injection region is less than the depth of the initial epitaxial layer and is also less than the depth of the trench gate in the initial epitaxial layer, and the depth is a depth value in the direction parallel to the stacking direction of the substrate and the initial epitaxial layer. Specifically, the at least one second initial injection region may be only in contact with part of one side wall of the trench gate, or may be in contact with parts of two side walls of the trench gate respectively. In a case that the first initial injection region is only in contact with part of one side wall of the trench gate, the second initial injection region and the first initial injection region are located on the same side of the trench gate. The total depth of the second initial injection region and the first initial injection region is less than or equal to the depth of the trench gate in the initial epitaxial layer.

Through the embodiment, first, the substrate and the initial epitaxial layer located on the substrate are provided; then, the first initial injection region, the second initial injection region adjacent to the first initial injection region and the third initial injection region adjacent to the second initial injection region are formed in the initial epitaxial layer along the direction close to the substrate, where the conduction types of the initial epitaxial layer, the first initial injection region and the third initial injection region are the same and are different from the conduction type of the second initial injection region, and the doping concentration of the third initial injection region is higher than the doping concentration of the initial epitaxial layer; and finally, the trench gate penetrating through the first initial injection region and the second initial injection region and having part of the bottom located in the third initial injection region is formed, and the remaining first initial injection region, the remaining second initial injection region, the remaining third initial injection region and the remaining initial epitaxial layer correspondingly form the first injection region, the second injection region, the third injection region and the epitaxial layer, thereby achieving the purpose of providing the third injection region with the same doping type of doped ions as the epitaxial layer and having a doping concentration higher than that of the epitaxial layer in the epitaxial layer at the bottom of the trench gate. Due to the presence of the third injection region, when a voltage is applied to the gate electrode and source electrode of the trench-gate-type silicon carbide power device and reaches a device threshold voltage, a carrier path from the first injection region through the second injection region and the third injection region to the epitaxial layer is formed first, that is, carrier pass through the first injection region, flow through an inversion layer channel formed in the second injection region, and then flow towards the epitaxial layer and the substrate through the third injection region, thereby ensuring relatively small path resistance, and effectively solving the technical problem of relatively high conduction resistance of a trench-gate-type silicon carbide power device in the prior art.

In an optional solution, a specific implementation of step S202: the first initial injection region, the second initial injection region and the third initial injection region are formed in the initial epitaxial layer may include:
Step S2021: as shown in Fig. 3 and Fig. 4, a fourth initial injection region 26 is formed in the initial epitaxial layer 22, where a width of the fourth initial injection region 26 in a first direction is the same as a width of the initial epitaxial layer 22 in the first direction, a width of the fourth initial injection region 26 in a second direction is less than a width of the initial epitaxial layer 22 in the second direction, conduction types of doped ions of the fourth initial injection region 26 and doped ions of the initial epitaxial layer are different, the first direction is perpendicular to a stacking direction of the substrate 10 and the initial epitaxial layer 22, and the second direction is parallel to the stacking direction.

Specifically, the fourth initial injection region may be formed in the initial epitaxial layer by high-temperature ion injection, and the doping concentration of doped ions of the fourth initial injection region may be E17-E18 cm⁻³. The width of the fourth initial injection region is the same as the width of the initial epitaxial layer, and the injection depth of the fourth initial injection region is less than the thickness of the initial epitaxial layer.

Step S2022: as shown in Fig. 4 to Fig. 6, the first initial injection region 23 is formed in the fourth initial injection region 26, where a width of the first initial injection region 23 in the first direction is less than the width of the fourth initial injection region 26 in the first direction, a width of the first initial injection region 23 in the second direction is less than the width of the fourth initial injection region 26 in the second direction, and a remaining fourth initial injection region 26 forms the second initial injection region 24.

Specifically, the first initial injection region is formed in the fourth initial injection region by high-temperature ion injection, and the doping concentration of doped ions of the first initial injection region may be E19 cm⁻³-E20 cm⁻³. The injection depth of the first initial injection region is less than the injection depth of the fourth initial injection region, and the injection width of the first initial injection region is also less than the injection width of the fourth initial injection region.

In the present disclosure, as shown in Fig. 4 to Fig. 6, the first initial injection region 23 is formed in the fourth initial injection region 26 may include the following steps: as shown in Fig. 4 and Fig. 5, a sixth initial injection region 29 is formed in the fourth initial injection region 26, and the remaining fourth initial injection region 26 forms the second initial injection region 24, thereby obtaining a structure as shown in Fig. 5, where a width of the sixth initial injection region 29 in the first direction is equal to the width of the fourth initial injection region 26 in the first direction, and a width of the sixth initial injection region 29 in the second direction is less than the width of the fourth initial injection region 26 in the second direction; an initial barrier layer is formed on an exposed surface of the sixth initial injection region 29, and then, edges of the initial barrier layer are removed by etching to form an injection window (not shown in the figure); and ion injection is performed on the sixth initial injection region 29 through the injection window to obtain the fifth injection region 30, and a remaining sixth initial injection region 29 forms the first initial injection region 23, thereby obtaining a structure as shown in Fig. 6. By forming the fifth injection region, parasitic triode conduction of the device may be prevented.

Specifically, the sixth initial injection region may be formed in the fourth initial injection region by high-temperature ion injection, and the fifth injection region may be formed in the sixth initial injection region by high-temperature ion injection. The doping concentration of doped ions of the sixth initial injection region may be E19 cm⁻³-E20 cm⁻³. The doping concentration of doped ions of the fifth injection region may be E19 cm⁻³-E21 cm⁻³.

Step S2023: as shown in Fig. 7, a fifth initial injection region 27 is formed in the initial epitaxial layer 22, where the fifth initial injection region 27 is located on part of the surface of the second initial injection region 24 close to the substrate 10, and the conduction types of doped ions of the fifth initial injection region 27 and the doped ions of the initial epitaxial layer 22 are different.

Specifically, an initial barrier layer may be first formed on an exposed surface of the initial epitaxial layer, part of the initial barrier layer is then removed by etching to form an injection window, and high-temperature and high-energy ion injection is performed through the injection window to form the fifth initial injection region. The conduction type of doped ions of the fifth initial injection region may be E17 cm⁻³-E18 cm⁻³.

Step S2024: as shown in Fig. 8, the third initial injection region 25 located in the initial epitaxial layer 22 and the fifth initial injection region 27 is formed, where the third initial injection region 25 is in contact with the surface of the second initial injection region 24 close to the substrate 10, and a remaining fifth initial injection region 27 forms a middle injection region 31.

Specifically, an initial barrier layer may be first formed on an exposed surface of the initial epitaxial layer, part of the initial barrier layer is then removed by etching to form an injection window, an orthographic projection of the injection window on the substrate is partially overlapped with an orthographic projection of the fifth initial injection region on the substrate, and high-temperature and high-energy ion injection is performed through the injection window to form the third initial injection region. The conduction type of doped ions of the third initial injection region may be E17 cm⁻³-E19 cm⁻³.

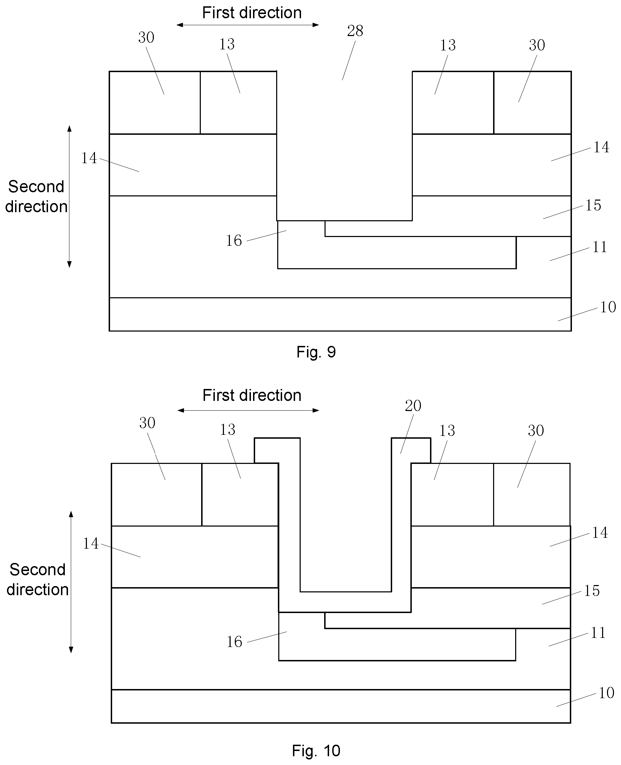

On this basis, step S203: the trench gate located in the initial epitaxial layer is formed, including:
Step S2031: as shown in Fig. 8 and Fig. 9, part of the first initial injection region 23, part of the second initial injection region 24, part of the third initial injection region 25 and part of the middle injection region 31 are removed, to form a trench 28 with part of the bottom located in the third initial injection region 25 and a remaining bottom in contact with the middle injection region 31, where the remaining first initial injection region 23 forms the first injection region 13, the remaining second initial injection region 24 forms the second injection region 14, the remaining third initial injection region 25 forms the third injection region 15, a remaining middle injection region 31 forms the fourth injection region 16, and the remaining initial epitaxial layer 22 forms the epitaxial layer 11.

Specifically, the depth of the trench is greater than a total injection depth of the first initial injection region and the second initial injection region and less than a total injection depth of the first initial injection region, the second initial injection region and the third initial injection region.

Step S2032: as shown in Fig. 9 and Fig. 10, the trench 28 and part of the surface of the at least one first injection region 13 away from the substrate 10 are covered with a gate oxide layer 20.

Specifically, the gate oxide layer may be grown in the trench by a high-temperature oxidation method. A thickness range of the gate oxide layer may be 40-60 nm.

Step S2033: as shown in Fig. 11, a remaining trench 28 is filled with a conductive material to form a gate electrode 21, where a surface of the gate electrode 21 away from the substrate 10 is flush with a surface of the gate oxide layer 20 away from the at least one first injection region 13, and the gate electrode 21 and the gate oxide layer 20 form the trench gate 12.

Specifically, the conductive material may be deposited in the remaining trench by a deposition method, and then, the gate electrode with a desired shape may be formed by photoetching. The conductive material may be polycrystalline silicon or other conductive materials.

In the embodiment, the fourth injection region with a conduction type of doped ions different from that of the epitaxial layer is provided at the bottom of the trench gate, so that the fourth injection region is in contact with part of the bottom of the trench gate and the third injection region respectively, and the fourth injection region and the second injection region respectively form PN junctions with the epitaxial layer. In this way, when a reverse voltage is applied to the trench-gate-type silicon carbide power device to enable the device to operate in a reverse state, by setting the conduction types of doped ions of the second injection region, the fourth injection region and the epitaxial layer, the PN junction formed by the fourth injection region and the epitaxial layer as well as the PN junction formed by the second injection region and the epitaxial layer are in a reverse biased state. In addition, as the reverse voltage increases, depletion layers of the two PN junctions are gradually expanded and connected, thereby effectively solving the problem of electric field concentration at the bottom of the trench, and ensuring that the breakdown voltage of the trench-gate-type silicon carbide power device is relatively high and the overall reliability of the device is better.

Further, the fourth injection region may be only in contact with the bottom of the trench gate. In order to further ensure better reliability of the device, in the present disclosure, the fourth injection region wraps the bottom corner of the trench gate. Since high electric fields are mainly concentrated at the bottom corner of the trench gate, by enabling the fourth injection region to wrap the bottom corner to form a corner wrapping trench shielding structure of the trench gate, the gate oxide layer of the bottom corner of the trench gate may be effectively protected, so as to further solve the problem of high electric field concentration at the bottom corner of the trench gate, and further improve the reliability of the trench gate.

After Step S203: the trench gate located in the initial epitaxial layer is formed, the method further includes: as shown in Fig. 11 and Fig. 12, an interlayer insulation layer 17 is formed on an exposed surface of the trench gate 12 and part of an exposed surface of the first injection region 13; as shown in Fig. 12 and Fig. 1, a source electrode metal layer 18 is formed on an exposed surface of the interlayer insulation layer 17 and an exposed surface of the epitaxial layer 11; and a drain electrode metal layer 19 is formed on the surface of the substrate 10 away from the epitaxial layer 11. In this embodiment, isolation and protection of the trench gate are achieved through the interlayer insulation layer. The source electrode metal layer serves as a source electrode of the device, and the drain electrode metal layer serves as a drain electrode of the device.

In the embodiment of the present disclosure, suitable materials may be selected as the materials of the interlayer insulation layer, such as silicon dioxide, silicon nitride and aluminum oxide. Of course, in addition to the mentioned materials, other insulating materials may also be selected as the materials of the interlayer insulation layer. Similarly, those skilled in the art may select any suitable conductive material as the material of the source electrode metal layer and the drain electrode metal layer, and the source electrode metal layer and the drain electrode metal layer may select a single-layer conductive structure or a multi-layer conductive structure.

Specifically, the interlayer insulation layer may be grown by an LPCVD method. The process of forming the source electrode metal layer may be as follows: a first metal layer, a second metal layer and a third metal layer are stacked in sequence on the exposed surface of the interlayer insulation layer and the exposed surface of the epitaxial layer, where the first metal layer is an Ni layer, the second metal layer is a Ti layer, and the third metal layer is an Al layer. The process of forming the drain electrode metal layer may be as follows: a fourth metal layer, a fifth metal layer, a sixth metal layer and a seventh metal layer are stacked in sequence on the surface of the substrate away from the epitaxial layer, where the fourth metal layer is an Ni layer, the fifth metal layer is a Ti layer, the sixth metal layer is an Ni layer, and the seventh metal layer is an Ag layer. The first metal layer, the second metal layer, the third metal layer, the fourth metal layer, the fifth metal layer, the sixth metal layer and the seventh metal layer specifically may be obtained by metal sputtering.

According to still another aspect of the present disclosure, a semiconductor structure is provided. The semiconductor structure includes: any one of the trench-gate-type silicon carbide power devices, or the trench-gate-type silicon carbide power device manufactured by the method.

The semiconductor structure includes the trench-gate-type silicon carbide power device, or the trench-gate-type silicon carbide power device obtained by the method. In the device, the third injection region with the same doping type of doped ions as the epitaxial layer is provided in the epitaxial layer at the bottom of the trench gate, and the doping concentration of doped ions of the third injection region is higher than the doping concentration of doped ions of the epitaxial layer. Due to the presence of the third injection region, when a voltage is applied to the gate electrode and source electrode of the trench-gate-type silicon carbide power device and reaches a device threshold voltage, a carrier path from the first injection region through the second injection region and the third injection region to the epitaxial layer is formed first, that is, carrier pass through the first injection region, flow through an inversion layer channel formed in the second injection region, and then flow towards the epitaxial layer and the substrate through the third injection region, thereby ensuring relatively small path resistance, and effectively solving the technical problem of relatively high conduction resistance of a trench-gate-type silicon carbide power device in the prior art.

It should also be noted that the terms "include", "contain" or any other variants thereof are intended to cover non-exclusive inclusions. Therefore, a process, method, commodity or device including a series of elements includes not only those elements, but also other elements that are not explicitly listed, or further includes elements inherent to such process, method, commodity or device. Without more limitations, an element defined by the statement "include one ..." does not exclude the existence of other same elements in the process, method, commodity or device that includes the element.

From the above description, it may be seen that the embodiments of the present disclosure achieve the following technical effects:
(1) In the trench-gate-type silicon carbide power device of the present disclosure, the third injection region with the same doping type of doped ions as the epitaxial layer is provided in the epitaxial layer at the bottom of the trench gate, and the doping concentration of doped ions of the third injection region is higher than the doping concentration of doped ions of the epitaxial layer. Due to the presence of the third injection region, when a voltage is applied to the gate electrode and source electrode of the trench-gate-type silicon carbide power device and reaches a device threshold voltage, a carrier path from the first injection region through the second injection region and the third injection region to the epitaxial layer is formed first, that is, carriers pass through the first injection region, flow through an inversion layer channel formed in the second injection region, and then flow towards the epitaxial layer and the substrate through the third injection region, thereby ensuring relatively small path resistance, and effectively solving the technical problem of relatively high conduction resistance of a trench-gate-type silicon carbide power device in the prior art.
(2) **In** the method for manufacturing the trench-gate-type silicon carbide power device of the present disclosure, first, the substrate and the initial epitaxial layer located on the substrate are provided; then, the first initial injection region, the second initial injection region adjacent to the first initial injection region and the third initial injection region adjacent to the second initial injection region are formed in the initial epitaxial layer along the direction close to the substrate, where the conduction types of the initial epitaxial layer, the first initial injection region and the third initial injection region are the same and are different from the conduction type of the second initial injection region, and the doping concentration of the third initial injection region is higher than the doping concentration of the initial epitaxial layer; and finally, the trench gate penetrating through the first initial injection region and the second initial injection region and having part of the bottom located in the third initial injection region is formed, and the remaining first initial injection region, the remaining second initial injection region, the remaining third initial injection region and the remaining initial epitaxial layer correspondingly form the first injection region, the second injection region, the third injection region and the epitaxial layer, thereby achieving the purpose of providing the third injection region with the same doping type of doped ions as the epitaxial layer and having a doping concentration higher than that of the epitaxial layer in the epitaxial layer at the bottom of the trench gate. Due to the presence of the third injection region, when a voltage is applied to the gate electrode and source electrode of the trench-gate-type silicon carbide power device and reaches a device threshold voltage, a carrier path from the first injection region through the second injection region and the third injection region to the epitaxial layer is formed first, that is, carrier pass through the first injection region, flow through an inversion layer channel formed in the second injection region, and then flow towards the epitaxial layer and the substrate through the third injection region, thereby ensuring relatively small path resistance, and effectively solving the technical problem of relatively high conduction resistance of a trench-gate-type silicon carbide power device in the prior art.

The above embodiments are merely exemplary embodiments of the present disclosure and are not intended to limit the present disclosure. It will be apparent to those skilled in the art that various modifications and changes may be made in the present disclosure. Any modifications, equivalent replacements and improvements made within the spirit and principle of the present disclosure shall be included within the scope of protection of the present disclosure.

## Claims

1. A trench-gate-type silicon carbide power device, comprising:
a substrate;
an epitaxial layer, which is located on a surface of the substrate;
a trench gate, which is at least located in the epitaxial layer;
at least one first injection region, which is located in the epitaxial layer on at least one side of the trench gate and is in contact with part of a side wall of the trench gate, a surface of the at least one first injection region away from the substrate being overlapped with part of a surface of the epitaxial layer away from the substrate;
at least one second injection region, which is located in the epitaxial layer on at least one side of the trench gate, is in contact with part of the side wall of the trench gate, and is further in contact with a surface of the at least one first injection region close to the substrate; and
a third injection region, which is located in the epitaxial layer and is in contact with part of a bottom of the trench gate, part of the side wall of the trench gate and part of a surface of the at least one second injection region close to the substrate respectively, and
conduction types of doped ions of the epitaxial layer, doped ions of the at least one first injection region and doped ions of the third injection region being same and being different from a conduction type of doped ions of the at least one second injection region, and a doping concentration of the doped ions of the third injection region being greater than a doping concentration of the doped ions of the epitaxial layer.

2. The trench-gate-type silicon carbide power device according to claim 1, wherein the trench-gate-type silicon carbide power device further comprises:
a fourth injection region, which is located in the epitaxial layer, is in contact with part of a surface of the third injection region close to the substrate and is further in contact with part of the bottom of the trench gate, conduction types of doped ions of the fourth injection region and the doped ions of the epitaxial layer being different.

3. The trench-gate-type silicon carbide power device according to claim 2, wherein the fourth injection region wraps a bottom corner of the trench gate.

4. The trench-gate-type silicon carbide power device according to any one of claims 1 to 3, wherein both first injection regions and second injection regions are located on two sides of the trench gate and are in contact with parts of two side walls of the trench gate respectively, and the third injection region only covers one bottom corner of the trench gate and part of the side wall of the trench gate located on a same side of the bottom corner and the surface of one of the second injection regions close to the substrate located on the same side of the bottom corner.

5. The trench-gate-type silicon carbide power device according to any one of claims 1 to 3, wherein the trench-gate-type silicon carbide power device further comprises:
an interlayer insulation layer, which is located on a surface of the trench gate away from the substrate and the surface of the at least one first injection region away from the substrate;
a source electrode metal layer, which is located on a surface of the epitaxial layer away from the substrate and a surface of the interlayer insulation layer away from the substrate; and
a drain electrode metal layer, which is located on a surface of the substrate away from the epitaxial layer.

6. The trench-gate-type silicon carbide power device according to any one of claims 1 to 3, wherein the trench gate comprises:
a trench, which is located in the epitaxial layer;
a gate oxide layer, which is located on side walls of the trench, a bottom of the trench and part of the surface of the at least one first injection region away from the substrate; and
a gate electrode, which is located on a surface of the gate oxide layer away from the substrate, a surface of the gate electrode away from the substrate being flush with the surface of the gate oxide layer away from the at least one first injection region.

7. The trench-gate-type silicon carbide power device according to claim 1, wherein the trench-gate-type silicon carbide power device further comprises:
at least one fifth injection region, which is located in the epitaxial layer on at least one side of the trench gate, is in contact with the surface of the at least one first injection region away from the side wall of the trench gate, and is further in contact with part of the surface of the at least one second injection region away from the substrate, and a surface of the at least one fifth injection region away from the substrate being overlapped with part of the surface of the epitaxial layer away from the substrate, conduction types of doped ions of the at least one fifth injection region and the doped ions of the at least one second injection region being same, and a doping concentration of doped ions of the at least one fifth injection region being greater than the doping concentration of doped ions of the at least one second injection region.

8. A method for manufacturing the trench-gate-type silicon carbide power device according to any one of claims 1 to 7, comprising:
providing a substrate and an initial epitaxial layer located on the substrate;
forming a first initial injection region, a second initial injection region and a third initial injection region in the initial epitaxial layer, a surface of the first initial injection region away from the substrate being overlapped with part of a surface of the initial epitaxial layer away from the substrate, the second initial injection region being located on a surface of the first initial injection region close to the substrate, the third initial injection region being located on part of a surface of the second initial injection region close to the substrate, conduction types of doped ions of the initial epitaxial layer, doped ions of the first initial injection region and doped ions of the third initial injection region being same and being different from a conduction type of doped ions of the second initial injection region, and a doping concentration of the doped ions of the third initial injection region being greater than a doping concentration of the doped ions of the initial epitaxial layer; and
forming a trench gate located in the initial epitaxial layer, the trench gate sequentially penetrating through the first initial injection region and the second initial injection region, part of a bottom of the trench gate being located in the third initial injection region, a remaining first initial injection region forming at least one first injection region, a remaining second initial injection region forming at least one second injection region, a remaining third initial injection region forming a third injection region, and a remaining initial epitaxial layer forming an epitaxial layer.

9. The method according to claim 8, wherein
forming the first initial injection region, the second initial injection region and the third initial injection region in the initial epitaxial layer comprising:
forming a fourth initial injection region in the initial epitaxial layer, a width of the fourth initial injection region in a first direction being same as a width of the initial epitaxial layer in the first direction, a width of the fourth initial injection region in a second direction being less than a width of the initial epitaxial layer in the second direction, conduction types of doped ions of the fourth initial injection region and the doped ions of the initial epitaxial layer being different, the first direction being perpendicular to a stacking direction of the substrate and the initial epitaxial layer, and the second direction being parallel to the stacking direction;
forming the first initial injection region in the fourth initial injection region, a width of the first initial injection region in the first direction being less than the width of the fourth initial injection region in the first direction, a width of the first initial injection region in the second direction being less than the width of the fourth initial injection region in the second direction, and a remaining fourth initial injection region forming the second initial injection region;
forming a fifth initial injection region in the initial epitaxial layer, the fifth initial injection region being located on part of the surface of the second initial injection region close to the substrate, and conduction types of doped ions of the fifth initial injection region and the doped ions of the initial epitaxial layer being different;
forming the third initial injection region located in the initial epitaxial layer and the fifth initial injection region, the third initial injection region being in contact with the surface of the second initial injection region close to the substrate, and a remaining fifth initial injection region forming a middle injection region;
forming the trench gate located in the initial epitaxial layer comprising:
removing part of the first initial injection region, part of the second initial injection region, part of the third initial injection region and part of the middle injection region, to form a trench with part of the bottom located in the third initial injection region and a remaining bottom in contact with the middle injection region, the remaining first initial injection region forming the at least one first injection region, the remaining second initial injection region forming the second injection region, the remaining third initial injection region forming the third injection region, a remaining middle injection region forming the fourth injection region, and the remaining initial epitaxial layer forming the epitaxial layer;
covering the trench and part of the surface of the at least one first injection region away from the substrate with a gate oxide layer; and
filling a remaining trench with a conductive material to form a gate electrode, a surface of the gate electrode away from the substrate being flush with a surface of the gate oxide layer away from the at least one first injection region, and the gate electrode and the gate oxide layer forming the trench gate.

10. A semiconductor structure, comprising: the trench-gate-type silicon carbide power device according to any one of claims 1 to 7, or the trench-gate-type silicon carbide power device manufactured by the method according to claim 8 or 9.
